# EUROPEAN PATENT APPLICATION

(11) **EP 1 197 994 A1**
(43) Date of publication of application: **17.04.2002**
(21) Application number: 00929882.9
(22) Date of filing: 26.05.2000
(51) Int. Cl.: H01L 21/205, H01L 21/3065, C23C 16/44

(54) **APPARATUS FOR MANUFACTURING SEMICONDUCTOR DEVICE**

(30) Priority: 27.05.1999 JP 14813899
(71) Applicant: Applied Materials, Inc., Santa Clara, California 95054 (US)
(72) Inventor: SAITO, Kazuyoshi, Narita-shi, Chiba 286-8516 (JP); TAKAGI, Youji, Narita-shi, Chiba 286-8516 (JP)
(74) Representative: Cross, Rupert Edward Blount
(86) International application number: JP0003410
(87) International publication number: WO0074125

(57) **Abstract**

An epitaxial growth device (1) is provided with a processing chamber (2) having a gas supply port (3) through which reactive gas (Go) is supplied and a gas exhaust port (4) for discharging exhaust gas (Gh) generated by the processing. An exhaust piping (8) for discharging exhaust gas (Gh) to an exhaust gas processing device (7) is connected with exhaust port (4) of this processing chamber (2). Locations in this exhaust piping (8) that make contact with the exhaust gas (Gh) are covered with a coating film (C) containing polyimide or Teflon. In this way, corrosion of the inside face etc of exhaust piping (8) can be prevented.

## Description

### TECHNICAL FIELD

The present invention relates to a semiconductor manufacturing device such as an epitaxial growth device.

### BACKGROUND ART

Typically, the conventional epitaxial growth device comprises a processing chamber having a susceptor that supports for example a semiconductor wafer constituting an article to be processed, a gas supply port and a gas exhaust port. In such a conventional device, a thin film is formed on the wafer surface by placing a wafer on the susceptor and heating it and feeding reactive gas into the processing chamber from the gas supply port.

The exhaust gas generated by such deposition processing is discharged to the outside through an exhaust piping etc from the gas exhaust port. To prevent corrosion, for example an electrolytic polished pipe finished to a specular surface, in which the layer of the inner surface that has been denatured by processing has been thoroughly removed by electrolytic polishing is commonly used for the exhaust piping.

### DISCLOSURE OF THE INVENTION

As a result of meticulous study of the deposition processing employed in the aforementioned conventional epitaxial growth device, the present inventors discovered the following problems of the conventional device. Specifically:
(1) Even if metal of high corrosion resistance in respect of the exhaust gas components is employed as the material of the electrolytic polished pipe, weld burning and heat denaturing occur during welding of the exhaust piping and corrosion tends to proceed from these locations or their vicinity. That is, weld burning etc is a factor causing corrosion of the inside surface of the exhaust piping.
(2) If moisture is present within the exhaust piping, this moisture reacts with by-product components contained in the exhaust gas and the inside surface of the exhaust piping may thereby be corroded.
(3) If the exhaust piping is corroded as described above, there is a risk that this corrosion (corrosion products) may flow back into the processing chamber and adhere to the wafer that is being processed in the processing chamber.
   In view of the above, an object of the present invention is to provide a semiconductor manufacturing device wherein corrosion of the exhaust piping can be prevented and contamination of the article to be processed caused by corrosion of the exhaust piping reduced.

The inventors perfected the present invention as a result of further studies based on the discoveries described above, in order to achieve the above object. Specifically, a semiconductor manufacturing device according to the present invention comprises a processing chamber wherein an article to be processed is arranged and an exhaust piping connected with this processing chamber for discharging exhaust gas generated by processing of the article to be processed to the outside, the exhaust piping being provided with a coating film containing a resin having heat resistance and corrosion resistance with respect to the exhaust gas and that covers at least the surface that is contacted by the exhaust gas.

In other words, according to the present invention there is provided a semiconductor manufacturing device comprising a processing chamber wherein an article to be processed is arranged and an exhaust piping connected with this processing chamber for discharging exhaust gas generated by processing of the article to be processed to the outside, being provided with a coating film containing a resin whereby at least the surface in the exhaust piping that is contacted by the exhaust gas is covered with a resin having heat resistance and corrosion resistance with respect to the exhaust gas.

In the semiconductor manufacturing device constructed in this way, when the exhaust piping is welded, suitably at least the face that is contacted by the exhaust gas is formed after welding with a coating film of a resin having corrosion resistance with respect to the exhaust gas. The likelihood of occurrence of corrosion caused by weld burning on contact with the exhaust gas is reduced at the locations covered by this coating film.

Also, since this resin has heat resistance, there is scarcely any possibility of the resin film peeling off due to the heat of the exhaust gas etc. Corrosion of the exhaust piping caused by reaction of moisture in the exhaust piping with by-products contained in the exhaust gas is also thereby suppressed. As a result, corrosion resistance of the exhaust piping is improved and deposition of contaminants onto the article to be processed arranged in the processing chamber can be very considerably alleviated.

Also, a semiconductor manufacturing device according to the present invention comprises a processing chamber in which is accommodated an article to be processed and an exhaust piping connected with this processing chamber and through which passes exhaust gas generated by processing of the article to be processed wherein at least the portion thereof that contacts this exhaust gas is covered with a coating film containing a resin that substantially screens or blocks components, of the components contained in the exhaust gas, that may corrode metal or components generated by reaction of such components with moisture.

In this way, contact of the metal forming the exhaust piping and corrosive components in the exhaust gas or corrosive components constituting reaction products of these components and moisture is prevented by the coating film (penetration of the corrosive components into the coating film is screened or blocked). Consequently, in a semiconductor manufacturing device constructed in this way, corrosion of the exhaust piping can be sufficiently suppressed.

Furthermore, when the exhaust piping is connected with the processing chamber by way of the sealing member, preferably the coating film is provided avoiding regions where the exhaust piping and sealing member make contact.

That is, in a semiconductor manufacturing device according to the present invention, preferably, the exhaust piping is connected with the processing chamber by way of a sealing member, and the coating film is provided avoiding the regions in the exhaust piping that come into contact with this sealing member. With such a construction, there is no possibility of impairing the sealing characteristics (sealing performance) of the sealing member, yet corrosion of the exhaust piping can be satisfactorily prevented.

Furthermore, when the exhaust piping consists of a plurality of piping sections connected by way of a sealing member, the coating film is suitably provided avoiding regions where the piping sections and the sealing member comes into contact.

That is, preferably the exhaust piping comprises a plurality of pipes, each of these pipes being connected by way of a sealing member, and the coating film is provided avoiding regions in each pipe with which the sealing members come into contact. In this way, the advantage is obtained that corrosion of the exhaust piping can be satisfactorily prevented without impairing the sealing characteristics of the sealing member.

More specifically, it is useful if the resin constituting the coating film is polyimide or polytetrafluoroethylene, or a composition including polyimide or polytetrafluoroethylene.

The inventors confirmed, in wafer processing with an epitaxial growth device using halogenated silane gas etc, when the coating of the prescribed locations within the exhaust piping with such resin was performed, that even better prevention of corrosion of the exhaust piping in such regions could be achieved compared with covering using other resins.

This is believed to be a reason why various types of polyimide resins and/or polytetrafluoroethylene, among resins, have excellent general characteristics in regard to corrosion resistance, heat resistance and strength etc and, in addition, for example, reduce the occurrence of pinholes in the coating film to a greater extent than would be anticipated. However, their actions are not limited to these.

### BRIEF DESCRIPTION OF THE DRAWINGS

Figure 1 is a diagrammatic cross-sectional view illustrating the construction of a preferred embodiment of a semiconductor manufacturing device according to the present invention, being a view illustrating diagrammatically an epitaxial growth device;
Figure 2 is an enlarged cross-sectional view illustrating a detail of a preferred embodiment of a semiconductor manufacturing device according to the present invention, being a view illustrating the region of the joint of the processing chamber and first pipe shown in Figure 1; and
Figure 3 is an enlarged cross-sectional view illustrating a further detail of a preferred embodiment of a semiconductor manufacturing device according to the present invention, being a view illustrating the region of the joint of the first pipe and second pipe shown in Figure 1.

### BEST MODE FOR CARRYING OUT THE INVENTION

A preferred embodiment of the present invention is described in detail below with reference to the appended drawings. In the description of the drawings, identical elements are given the same reference symbols and duplicated description is thereby avoided. Also, positional relationships such as up/down and left/right, unless otherwise specified, are in accordance with the up/down and left/right etc positional relationships of the drawings.

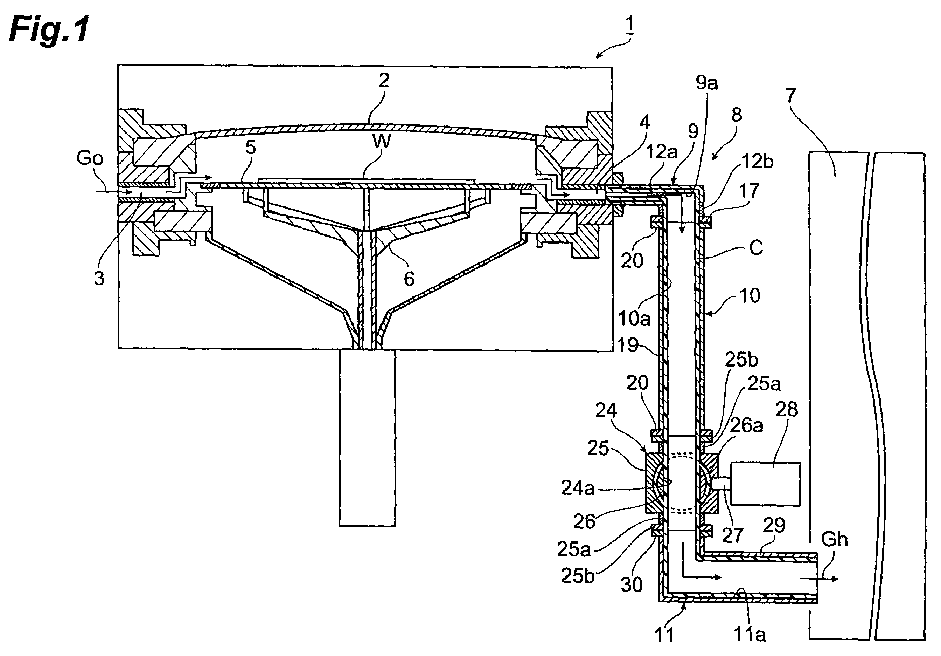

Figure 1 is a diagrammatic cross-sectional view illustrating the construction of a preferred embodiment of a semiconductor manufacturing device according to the present invention, and illustrates diagrammatically a single wafer type epitaxial growth device for deposition processing of articles to be processed constituted by silicon wafers, one wafer at time.

Epitaxial growth device 1 is equipped with processing chamber 2 made of quartz glass. On the side walls of this processing chamber 2, gas supply port 3 for supplying reactive gas Go into processing chamber 2 and gas exhaust port 4 for discharging exhaust gas Gh generated within processing chamber 2 are provided facing each other.

Within processing chamber 2, there is provided disc-shaped susceptor 5 made of graphite material covered with silicon carbide. Wafer W is supported on the upper surface of this susceptor 5.

Susceptor 5 is horizontally supported at three points from its back face by means of a support shaft made of quartz glass erected at the bottom of processing chamber 2. This support shaft 6 is driven in rotation by a drive motor, not shown and susceptor 5 is thereby rotated.

Also, above and below susceptor 5 in processing chamber 2 there are arranged a plurality of halogen lamps, not shown, whereby wafer W placed on susceptor 5 is heated.

Furthermore, exhaust piping 8 for discharging exhaust gas to external exhaust gas processing device 7 is connected with processing chamber 2. This exhaust piping is formed of metal, such as for example electrolytic polished stainless steel.

Furthermore, as exhaust piping 8, there are coupled, in this order, respective piping sections, namely, first pipe 9, second pipe 10 and third pipe 11. Of these, first pipe 9 and third pipe 11 are so-called L pipes forming a letter L shape and second pipe 10 is a so-called straight pipe forming a straight line shape.

In exhaust piping 8 which is unitarily constructed from these piping sections in this way, first pipe 9 is connected with gas exhaust port 4 of processing chamber 2 and third pipe 11 is connected with exhaust gas processing device 7.

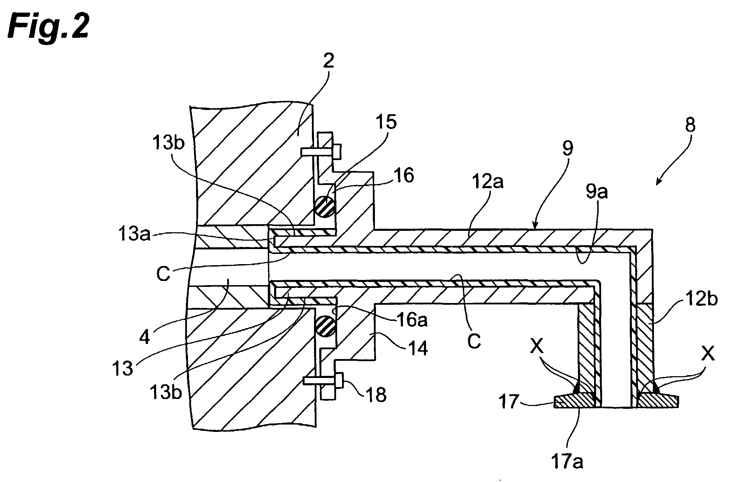

Figure 2 is a cross-sectional view (part omitted) to a larger scale illustrating the construction of the region of the joint of processing chamber 2 and first pipe 9 shown in Figure 1. As shown in this Figure, in first pipe 9, piping section 12b of approximately cylindrical shape is joined by welding to box 12a. Insertion section 13 that is inserted at gas exhaust port 4 is provided at the end on the side that is connected with processing chamber 2 in this box 12a.

Also, at a position adjacent this processing section 13, there is provided projection 14 for connection purposes, having a step. This connecting projection 14 is formed with annular groove 16 in which is accommodated O-ring 15 (sealing member) for sealing purposes.

Also, as shown in Figure 2, in a condition in which O-ring 15 is accommodated in annular groove 16 and insertion section 13 is inserted at gas exhaust port 4, connecting projection 14 is fixed to the side wall of processing chamber 2 by a plurality of screws 18. In this way, first pipe 9 is connected with processing chamber 2.

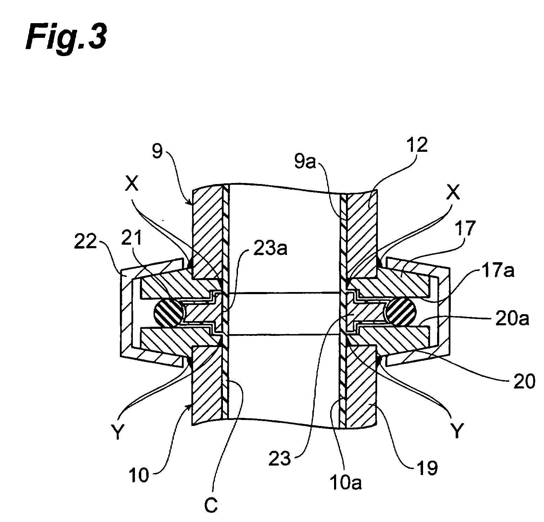

Furthermore, at the end which is not connected with box 12a in piping section 12b, ring-shaped connecting flange 17 is joined by welding at weld X. Figure 3 is a cross-sectional view to a larger scale (part omitted) illustrating the construction of the region of the connection of first pipe 9 and second pipe 10 illustrated in Figure 2. As described above, second pipe 10 is connected with first pipe 9. In Figure 3, second pipe 10 has cylindrical pipe body 19. Connecting flanges 20 having the same construction as connecting flange 17 of first pipe 9 are joined by welding at welds Y at both ends of this pipe body 19.

Connecting flange 17 of first pipe 9 and connecting flange 20 of second pipe 10 are butt-jointed in a condition with O-ring 21 (sealing member) for sealing purposes therebetween. Also, connecting flanges 17, 20 are clamped by a plurality of U-shaped clamping members 22. In this way, first pipe 9 and second pipe 10 are connected.

It should be noted that center ring 23 of convex cross section is arranged on the inside of O-ring 21 to prevent O-ring 21 escaping inwards.

Returning to Figure 1, between second pipe 10 and third pipe 11, valve 24 is provided that controls the flow of exhaust gas from within processing chamber 2. This valve 24 is a ball valve comprising housing 25 and moveable section 26 of spherical surface shape capable of sliding with respect to this housing 25.

In moveable section 26, there is formed through-hole 26a of cylindrical shape through which exhaust gas can flow and through which gas passes to exhaust piping 8 from processing chamber 2. Also, the output shaft of drive actuator 28 is coupled with moveable section 26 by means of frame 27. Moveable section 26 is driven when this drive actuator 28 is driven in rotation. In this way, connection or disconnection of second pipe 10 and third pipe 11 is achieved by means of valve 24.

Furthermore, connecting flanges 25b (having the same construction as connecting flange 17 of first pipe 9) are joined by welding by way of respective cylindrical piping sections 25a to both ends of housing 25 constituting valve 24. Connecting flange 20 of second pipe 10 is coupled with one of these connecting flanges 25b.

Also, in the case of third pipe 11, connecting flange 30 is joined by welding to one end of L-shaped pipe body 29. This connecting flange 30 is connected with the other of connecting flanges 25b. The means for connecting these adjacent flanges is the same as shown in Figure 3.

Also, the face of exhaust piping 8 contacted by exhaust gas Gh that is discharged from processing chamber 2 is coated with coating film C which has corrosion resistance and heat resistance and comprises a resin capable of substantially screening or blocking components, of the components making up the exhaust gas Gh, that present a risk of corroding metal or components produced by reaction of such components with moisture.

Preferably in particular various types of polyimide resin and/or polytetrafluoroethylene (PTFE, hereinbelow referred to as "Teflon") are employed as this resin. Also, coating film C may consist solely of this resin or may be formed by a resin composition containing, in addition to this resin, various types of additive such as various types of thermal stabilizer, lubricant, oxidation preventing agent, coloring agent, foaming agent, processing stabilizer, organic or inorganic filler or other resins.

As specific examples, locations where this coating film C is formed include inside face 9a of first pipe 9 (box 12a, piping section 12b and connecting flange 17), inside face 10a of second pipe 10 (pipe body 19 and the two connecting flanges 20), inside face 11a of third pipe 11 (pipe body 29 and connecting flange 30), inside face 24a of valve 24 (housing 25, moveable section 26, piping section 25a and connecting flange 25b) and, in addition, connecting faces 13a, 13b with processing chamber 2 in insertion section 13 of first pipe 10 (see Figure 2) and the entire surface 23a (see Figure 3) of center ring 23.

No coating film C comprising the aforementioned resin is formed on the bottom face 16a (see Figure 2) of annular groove 16 of first pipe 9, the connecting faces of first pipe 9 and second pipe 10 i.e. the opposite faces 17a, 20a of connecting flanges 17, 20 (see Figure 3), the connecting faces of second pipe 10 and valve 24 i.e. the opposite faces of connecting flanges 20 and 25b or the connecting faces of valve 24 and third pipe 11 i.e. the opposite faces of connecting flanges 25b, 30. In this way, impairment of the sealing ability of O-rings 15 and 21 that abut these faces can be prevented. There is therefore no possibility of exhaust gas Gh leaking from such connections.

The process of forming coating film C on these pipes 9 to 11 is performed for each member after assembling pipes 9 to 11 by welding etc. By forming coating film C after welding, occurrence of metal corrosion caused by weld burning can be satisfactorily suppressed.

Also, processing for forming coating film C on valve 24 is suitably performed in a condition with housing 25 and moveable section 26 disassembled. In this way, coating film C can be easily and conveniently formed on valve 24. It should be noted that, with a view to simplifying the resin covering treatment, coating film C may be formed on all faces including the external faces of pipes 9 to 11 and valve 24 except for the regions where O-rings 15 and 21 make contact.

Deposition processing using epitaxial growth device 1 constructed in this way is described below. First of all, wafer W is placed on susceptor 5 in a condition with the interior of processing chamber 2 maintained at normal pressure (for example about 740 to 780 Torr). Then, susceptor 5 is rotated whilst heating wafer W by means of halogen lamps, not shown, and reactive gas Go such as trichlorosilane (SiHCl₃) gas is supplied into processing chamber 2 from gas supply port 3.

When this is done, the reactive gas Go flows in laminar flow condition along the surface of wafer W that has been heated to a prescribed temperature, and a thin film is formed by epitaxial growth of single crystals of silicon on wafer W. At this point, valve 24 is in an open condition so exhaust gas Gh generated by deposition processing is delivered from the gas exhaust port 4 through exhaust piping 8 to exhaust gas processing device 7.

Corrosive by-products such as for example hydrogen chloride (HCl) are present in this exhaust gas Gh. When these by-products react with moisture present in the exhaust piping 8, the internal surface of exhaust piping 8 may be corroded. Metal contamination is thereby produced, with the risk that this contamination may flow back through exhaust piping 8 into the interior of processing chamber 2 and thereby be deposited on wafer W.

However, in the case of epitaxial growth device 1, coating film C containing for example polyimide or Teflon, which has corrosion resistance in respect of hydrogen chloride is provided on the surface in exhaust piping 8 that makes contact with exhaust gas Gh, so corrosion of the internal surface of exhaust piping 8 due to reaction between the moisture present in exhaust piping 8 and by-products present in the exhaust gas Gh can be satisfactorily suppressed.

Furthermore, since polyimide and Teflon have excellent heat resistance (specifically, the heat resistance temperature of polyimide is at least 350°, and the heat resistance temperature of Teflon is at least 280°), there is scarcely any possibility that the coating of resin (coating film C) will be peeled off by the heat of the exhaust gas Gh etc. Also, since the processing for forming coating film C is performed after the welding operation of pipes 9 to 11, corrosion of the internal surface of exhaust piping 8 caused by weld burns etc can be sufficiently prevented.

Furthermore, with polyimide or Teflon coatings, generation of pinholes is extremely uncommon. Corrosion resistance of exhaust piping 8 can therefore be improved and a further reduction in deposition of contamination on wafer W on susceptor 5 achieved. Furthermore, since coating film C is provided avoiding the regions in exhaust piping 8 that make contact with O-rings 15, 21, the advantage is obtained that corrosion of the internal surface of exhaust piping 8 can be reliably prevented without impairing sealing characteristics of O-rings 15 and 21.

The present invention is of course not restricted to the embodiment described above. For example, although, in the embodiment described above, polyimide or Teflon coating of high corrosion resistance in respect of chlorine-based gases was applied to the internal surface etc of exhaust piping 8, the resin employed is not particularly restricted to these, and any resin having corrosion resistance in respect of the exhaust gas and heat resistance could be employed. Also, apart from a ball valve, valve 24 could be for example a gate valve. Furthermore, the present invention could also be applied to semiconductor manufacturing devices apart from epitaxial growth device 1 such as for example CVD devices or dry etching devices.

### INDUSTRIAL APPLICABILITY

As described in detail above, with the present invention, a coating of resin having corrosion resistance in respect of the exhaust gas and heat resistance is applied at least to locations in the exhaust piping that come into contact with exhaust gas. Contamination of the article to be processed can thus be reduced by preventing corrosion of the exhaust piping.

Also, since the locations in the exhaust piping that come into contact with the exhaust gas are covered with a coating film containing resin that substantially screens or blocks components, of the components contained in the exhaust gas, that are liable to corrode metal or components produced by reaction of these components with moisture, contamination of the article to be processed can be reduced by preventing corrosion of the exhaust piping.

## Claims

1. A semiconductor manufacturing device comprising a processing chamber in which an article to be processed is placed and an exhaust piping connected with the processing chamber for discharging exhaust gas generated by processing of the article to be processed to the outside,
said exhaust piping being provided with a coating film that comprises a resin having heat resistance and corrosion resistance with respect to the exhaust gas and that covers at least the surface that is contacted by the exhaust gas.

2. A semiconductor manufacturing device comprising:
a processing chamber in which an article to be processed is accommodated; and
an exhaust piping that is connected with said processing chamber and through so that exhaust gas generated by processing of said article to be processed is passed therethrough, at least the portion thereof that is contacted by said exhaust gas being covered with a coating film containing a resin that substantially screens or blocks components, of the components making up said exhaust gas, that are liable to corrode metal or components produced by reaction of these components with moisture.

3. The semiconductor manufacturing device according to claim 1 or claim 2 wherein said exhaust piping is connected with said processing chamber with a sealing member interposed therebetween, and said coating film is provided avoiding regions where said exhaust piping and said sealing member are in contact.

4. The semiconductor manufacturing device according to any of claim 1 to claim 3 wherein said exhaust piping comprises a plurality of piping sections connected with a sealing member interposed therebetween, and said coating film is provided avoiding regions where said exhaust piping and said sealing member are in contact.

5. The semiconductor manufacturing device according any of claim 1 to claim 4 wherein said resin is polyimide or polytetrafluoroethylene or a composition containing polyimide or polytetrafluoroethylene.
